(19) Europäisches Patentamt

European Patent Office

Office européen des brevets

(11) Veröffentlichungsnummer : **0 262 164 B1**

(12) **EUROPÄISCHE PATENTSCHRIFT**

(45) Veröffentlichungstag der Patentschrift :
**05.06.91 Patentblatt 91/23**

(21) Anmeldenummer : **87901338.1**

(22) Anmeldetag : **20.03.87**

(86) Internationale Anmeldenummer :
**PCT/CH87/00036**

(87) Internationale Veröffentlichungsnummer :
**WO 87/06070 08.10.87 Gazette 87/22**

(51) Int. Cl.⁵ : **H02M 7/537,** H03K 4/02,
H02M 7/797

(54) **EINRICHTUNG ZUR ERZEUGUNG EINER WECHSELSPANNUNG.**

(30) Priorität : **26.03.86 CH 1204/86**

(43) Veröffentlichungstag der Anmeldung :
**06.04.88 Patentblatt 88/14**

(45) Bekanntmachung des Hinweises auf die
Patenterteilung :
**05.06.91 Patentblatt 91/23**

(84) Benannte Vertragsstaaten :
**AT CH DE FR GB IT LI NL SE**

(56) Entgegenhaltungen :
**EP-A- 0 042 235**
**US-A- 3 909 685**
**Patent Abstracts of Japan, vol. 7, no. 222,**
**(E-201) (1367) 4 October 1983 & JP, A,**
**58112476**

(73) Patentinhaber : **JOHO, Reinhard**
**Lärchenstrasse 9**
**CH-5024 Küttigen (CH)**

(72) Erfinder : **JOHO, Reinhard**
**Lärchenstrasse 9**
**CH-5024 Küttigen (CH)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Einrichtung zur Erzeugung einer Wechselspannung mit niedriger Quellenimpedanz, welche entweder zum Zwecke der Spannungsstabilisierung parallel zu einem Netz geschaltet ist oder im Inselbetrieb angeschlossene Verbraucher speist.

In der EP-A-0042235 ist eine Einrichtung beschrieben, in der die Wechselspannung am Ausgang einer linear arbeitenden Brückenschaltung ansteht, die ihre Speisespannung über Schaltelemente aus einer gestuften Gleichspannungsquelle bezieht. Brückenschaltung und Schaltelemente werden dabei von einer Idealnetzspannungsquelle angesteuert, die Schaltelemente schalten dabei in vorgegebener Abhängigkeit vom Momentanwert der Idealnetzspannungsquelle. Die transistorisierte Brückenschaltung bewirkt die Halbwellenumschaltung und die Umformung der angelegten treppenförmigen Speisespannung in eine sinusförmige Ausgangsspannung. Die angeschlossenen Verbraucher oder Netze beziehen im allgemeinen einen zur Spannung phasenverschobenen Strom. Die in der Brückenschaltung enthaltenen Transistorglieder können aber keine Vorzeichenopposition zwischen Strom und Spannung verarbeiten. Dieser Mangel äussert sich durch Spannungsverzerrungen oder Ueberspannungen.

Demgegenüber arbeitet die erfindungsgemässe Schaltungsanordnung mit einem Umschalten Anodenanschlüsse beider einer transistorisierten Gegentakt-Komplementärschaltung auf einer symmetrischen gestuften Gleichspannungsquelle. Die Wechselspannung liegt dabei zwischen dem Ausgang der Gegentakt-Komplementärschaltung und dem Mittelpunkt der gestuften Gleichspannungsquelle an. Die Umschaltung wird in Funktion des Momentanwertes des Idealnetzspannung und der Stufenspannungen so gesteuert, dass in keinem Zeitpunkt eine vorgegebene Minimalarbeitsspannung über jedem der Transistoren unterschritten wird und dass deren Maximalarbeitsspannungen gleich der Summe aus Stufenspannung un Minimalarbeitsspannung werden.

Die erfindungsgemässe Einrichtung hat zum Vorteil, dass eine beliebige Phasenlage des Verbraucherstromes möglich ist und die gewünschte ideale Spannungsform nicht beeinträchtigt wird.

Im folgenden wird die Erfindung anhand der Beschreibung und eines Ausführungsbeispiels näher erläutert.

Fig. 1 zeigt die erfindungsgemässe Schaltungsanordnung.

Fig. 2 zeigt eine Schaltung zur Anspeisung der gestuften Gleichspannungsquelle.

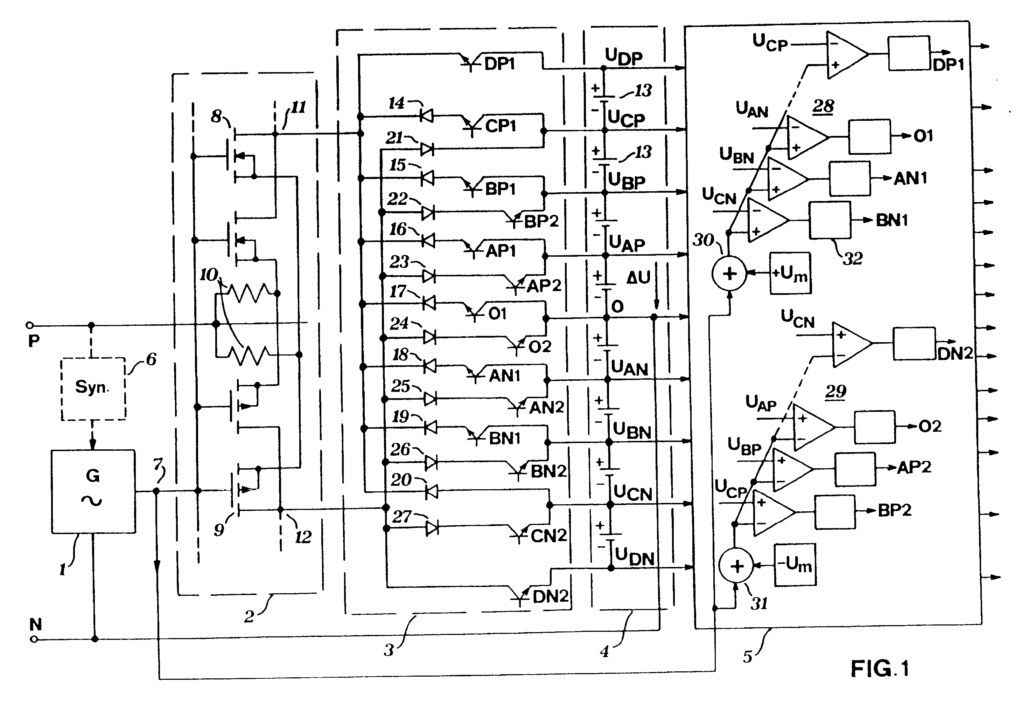

Die Einrichtung besteht aus einer Schaltungsanordnung gemäss Fig. 1, umfassend einen Idealnetzspannungsgenerator 1, eine transistorisierte Gegentakt-Komplementärschaltung 2, einen Schaltelektronikteil 3, eine gestufte Gleichspannungsquelle 4 und einen Steuerelektronikteil 5. Der Anschluss an das Netz oder an Verbraucher erfolgt über einen ersten und zweiten Leiter, z.B. den Polleiter P und den Nulleiter N.

Im Idealnetzspannungsgenerator 1 wird eine Idealnetzspannung, vorzugsweise eine sinusförmige Spannung, in tatsächlicher Amplitude leistungslos erzeugt. Bei Betrieb als Netzspannungsstabilisator wird die Idealnetzspannung ausserdem im Glied 6 phasenwinkeldeckend zur Netzspannung synchronisiert und mit einer vorgebbaren Zeitkonstante der Grundwellenamplitude der Netzspannung nachgeführt, die Gegentakt-Komplementärschaltung kann mit der in WO-A-86/04464 (Veröffentlichungstag 31.07.86) beschriebenen Ansprechschwelle versehen sein.

Der Ausgang 7 des Idealnetzspannungsgenerators geht auf den Steueranschluss der Gegentakt-Komplementärschaltung 2. Diese besteht aus je einer Parallelschaltung von n-Kanal-Querfeldtransistoren 8 und p-Kanal-Querfeldtransistoren 9, die für gleichmässige Stromaufteilung unter parallelen Transistoren und zur Strombegrenzung mit niederohmigen Kathodenwiderständen 10 versehen sind. Der Verbindungspunkt dieser Widerstände bildet den niederimpedanten Ausgang der Komplementärschaltung 2 und ist mit dem Polleiter P verbunden. Die Anodenanschlüsse 11, 12 der Querfeldtransistoren sind über den Schaltelektronikteil 3 mit der gestuften Gleichspannungsquelle 4 verbunden, deren spannungsmässiger Mittelpunkt 0 mit dem Nulleiter N verbunden ist. Die positive und die negative Summenspannung der Gleichspannungsquelle 4 sind im Betrag grösser als die Amplitude der erzeugten Wechselspannung. Die Spannungsquelle ist in gleich grosse, seriegeschaltete Spannungsstufen mit breitbandig niedriger Innenimpedanz unterteilt, was durch Serieschaltung von Akkumulatoren 13, aber auch durch seriegeschaltete induktivitätsarme Kondensatoren geschehen kann.

Im Schaltelektronikteil 3 werden die Anodenanschlüsse 11, 12 unterbruchsfrei unter den 9 Spannungsstufen umgeschaltet. Der bezüglich dem Nulleiter N positivere Anodenanschluss 11 der n-Kanal-Querfeldtransistoren 8 ist über die Dioden 14, 15, 16, 17, 18, 19 und die jeweils zu den Dioden in Serie liegenden Schalttransistoren CP1, BP1, AP1, O1, AN1, BN1 mit einzelnen Spannungsstufen $U_{CP}$, $U_{BP}$, $U_{AP}$, O, $U_{AN}$, $U_{BN}$, verbunden. Diese Schalttransistoren werden sukzessive aus dem negativen Spannungsbereich zum positiven Spannungsbereich zugeschaltet. Jedes Zuschalten einer nächstpositiveren Spannungsstufe bewirkt über die Dioden ein selbsttätiges Abkoppeln der darunterliegenden Spannungsstufen. Die positivste Spannungsstufe $U_{DP}$ mit dem Schalttransistor DP1 braucht keine Seriediode, die negativste benötigte Stufe $U_{CN}$ mit der Seriediode 20 braucht keinen Schalttransistor.

Genau reziproke Verhältnisse gelten für die Beschaltung des negativeren Anodenanschlusses 12 mit den Dioden 21, 22, 23, 24, 25, 26, 27 und den Schalttransistoren BP2, AP2, O2, AN2, BN2, CN2, DN2.

Der Steuerelektronikteil 5 steuert die Schalttransistoren so, dass die Anoden- Kathoden- Spannungen der Querfeldtransistoren 8, 9 in keinem Zeitpunkt kleiner als eine Minimalarbeitsspannung $U_m$ und in keinem Zeitpunkt grösser als die Summe aus Stufenspannung $\triangle U$ und Minimalarbeitsspannung $U_m$ werden.

Zu diesem Zweck werden für die Ansteuerung der beiden Anodenanschlüsse 11, 12 zwei Komparatorreihen 28 bzw. 29 vorgesehen, in denen der Momentanwert der Idealnetzspannung 7, in Addiergliedern 30 bzw. 31 um die Minimalarbeitsspannung $U_m$ vergrössert bzw. vermindert, mit den Stufenspannungen verglichen wird. Wenn die in Gliedern 30, 31 korrigierte Idealnetzspannung bei positivem Ansteigen eine Spannungsstufe erreicht hat, so wird für den positiveren Anodenanschluss 11 der Schalttransistor der nächstpositiveren Spannungsstufe leitend bzw. für den negativeren Anodenanschluss 12 der Schalttransistor der nächstnegativeren Stufe sperrend. Die Ansteuerung der Schalttransistoren erfolgt in bekannter Weise potentialtrennend über Optokoppler 32.

Die Stufenspannung $\triangle U$ richtet sich nach der zulässigen Anode-Kathode-Spannung und Verlustleistung der Querfeldtransistoren 8, 9 und liegt vorzugsweise im Bereich 50....200 V.

Die Minimalarbeitsspannung $U_m$ richtet sich nach dem minimalen Innenwiderstand der Querfeldtransistoren und dem zu liefernden Spitzenstrom, ferner nach der Amplitude allfälliger Spannungsoszillationen über den Akkumulatoren 13, bzw. Kondensatoren und liegt vorzugsweise im bereich 0,2- bis 0,4-facher Stufenspannung $\triangle U$.

Um Schaltoszillationen über den Akkumulatoren 13, bzw. Kondensatoren zu vermeiden, können die Komparatoren der Komparatorreihen 28, 29 auch mit einer leichten Schalthysterese versehen werden.

Bei Betrieb der Einrichtung als Netzspannungsstabilisator können in der Gleichspannungsquelle Kondensatoren verwendet werden. Die summierten positiven und negativen Stufenspannungen können in diesem Fall betragsmässig wesentlich grösser sein als die Amplitude der zu stabilisierenden Wechselspannung, um bei Netzausfall durch selbsttätiges Zuschalten höherer Spannungsstufen die Entladung der darunterliegenden Spannungsstufen auszugleichen. Paralleldioden zu den Kondensatoren der einzelnen Spannungsstufen schützen vor Umpolarisierung entladener Stufen.

Die Batterien oder Kondensatoren der einzelnen Spannungsstufen werden im Betrieb ungleich stark belastet. Vorzugsweise werden daher alle Spannungsstufen in paralleler Anspeisung, beispielsweise aus dem Netz, aufgeladen. Um der Grundschwingungslast gerecht zu werden, kann die installierte Stufenkapazität mit zunehmender Entfernung der Spannungsstufe vom Nulleiteranschluss 0 abnehmen. Bei Betrieb als Netzspannungsstabilisator kann es bei oberschwingungshaltiger Netzspannung aber auch zur Aufladung der Batterien oder Kondensatoren einzelner Spannungsstufen kommen. Dies würde zu einer permanenten Verzerrung des Gleichspannungsrasters und zu erhöhten Verlusten in den Querfeldtransistoren führen.

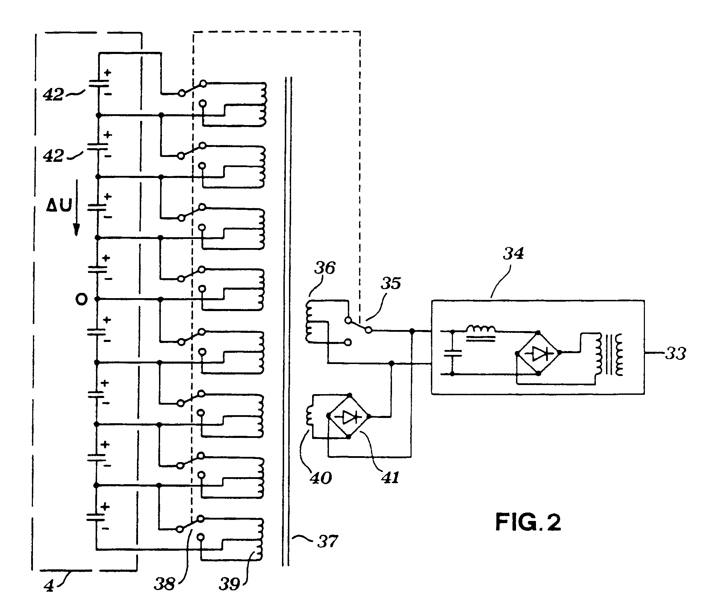

Die in Fig. 2 gezeigte Schaltungsvariante für die Gleichspannungsquelle 4 sorgt für eine Nivellierung der Stufenspannungen $\triangle U$ ohne Energie zu dissipieren. Ein hier aus dem Netz 33 gespiesener Gleichspannungszwischenkreis 34 wird, mit dem Schalter 35 elektronisch geschaltet, auf die Primärwicklung 36 eines Transformators 37 verbunden. Alle Spannungsstufen $\triangle U$ der Gleichspannungsquelle sind über elektronisch synchron zum Schalter 35 betriebene Schalter 38 mit untereinander gleichen Sekundärwicklungen auf den Transformator 37 verbunden. Die Schaltfrequenz der Schalter 35, 38 muss nicht netzfrequent sein, sondern kann auch wesentlich höher liegen. Eine weitere Wicklung 40 mit gleicher Windungszahl wie die halbe Primärwicklung 36 speist über einen Brückengleichrichter 41 in den primären Gleichspannungszwischenkreis 34 zurück und gewährleistet damit eine überspannungsarme Kommutierung. Wenn einer oder mehrere der Kondensatoren 42 der Spannungsstufen von der Gegentakt-Komplementärschaltung 2 aus Fig. 1 her aufgeladen oder entladen werden, so verteilen sie über den Transformator 37 die Ladeleistung bzw. Entladeleistung auf alle andern beteiligten Kondensatoren und steigen bzw. sinken in ihrer Spannung gegenüber den andern Kondensatoren nicht.

Die erfindungsgemässe Einrichtung hat einen guten Gesamtwirkungsgrad, während gleichzeitig die Transistoren der Gegentakt-Komplementärschaltung spannungs- und verlustmässig gering belastet werden. Bei Verwendung als autonome Wechselspannungsquelle bleibt auch bei verbraucherseitiger Teillast der gute Wirkungsgrad erhalten.

Die Frequenz der erzeugten Wechselspannung kann auch in einem andern Bereich als Netzfrequenz liegen und kann auch in irgendeiner zeitlichen Funktion stetig variieren.

Die Stufenzahl der Gleichspannungsquelle ist selbstverständlich nicht auf die im Beispiel gezeigten 9 Stufen fixiert.

Ansprüche     .

1. Einrichtung zur Erzeugung einer Wechselspannung mit niedriger Quellenimpedanz, bestehend aus einer Schaltungsanordnung mit einer transistorisierten Gegentaktschaltung (2), deren Ausgang einen ersten Leiter (P) der Wechselspannungsquelle bildet, einem Idealnetzspannungsgenerator (1), dessen Signal zwischen einem zweiten Leiter (N) und einem Steueranschluss der Gegentaktschaltung anliegt und einer bezüglich dem zweiten Leiter symmetrischen gestuften Gleichspannungsquelle (4) mit im wesentlichen gleich grossen Stufenspannungen $\triangle U$, dadurch gekennzeichnet, dass die Gegentaktschaltung als Komplementärschaltung ausgebildet ist und die Anodenanschlüsse (11, 12) der Transistoren (8, 9) der Gegentakt-Komplementärschaltung gesteuert vom Idealnetzspannungsgenerator unterbruchsfrei unter den Spannungsstufen so umgeschaltet werden, dass über jedem der Transistoren in keinem Zeitpunkt eine vorgegebene Minimalarbeitsspannung $U_m$ unterschritten wird und in keinem Zeitpunkt eine Maximalarbeitsspannung gleich der Summe aus Minimalarbeitsspannung $U_m$ und Stufenspannung $\triangle U$ überschritten wird.

2. Einrichtung nach Anspruch 1, dadurch gekennzeichnet, dass in einem Schaltelektronikteil (3) der Anodenanschluss (11) der n-Kanal-Transistoren mit im wesenlichen jeder Spannungsstufe ($U_{CP}$, $U_{BP}$, $U_{Ap}$, O, $U_{AN}$, $U_{BN}$) über eine Serieschaltung Diode-Schalttransistor (14, CP1 ; 15, BP1 ; 16, AP1 ; 17, O1 ; 18, AN1 ; 19, BN1) verbunden ist, und dass der Anodenanschluss (12) der p-Kanal-Transistoren mit im wesentlichen jeder Spannungsstufe ($U_{CN}$, $U_{BN}$, $U_{AN}$, O, $U_{AP}$, $U_{BP}$) über eine Serieschaltung Diode-Schalttransistor (27, CN2 ; 26, BN2 ; 25, AN2 ; 24, O2 ; 23, AP2 ; 22, BP2) verbunden ist.

3. Einrichtung nach Anspruch 1 und 2, dadurch gekennzeichnet, dass der Anodenanschluss (11) der n-Kanal-Transistoren nicht mit der oder den negativsten Spannungsstufen ($U_{DN}$) verbunden ist, dass die negativste verbundene Stufe ($U_{CN}$) nur über eine Diode (20) verbunden ist und die Verbindung mit der positivsten Stufe ($U_{DP}$) nur über einen Schalttransistor (DP1) erfolgt und dass für die Verbindung des Anodenanschlusses (12) der p-Kanal-Transistoren das sinngemäss Gleiche gilt.

4. Einrichtung nach Anspruch 1 und 2, dadurch gekennzeichnet, dass die Ansteuerung der Schalttransistoren im Schaltelektronikteil (3) durch einen Steuerelektronikteil (5) erfolgt, in dem der um den Betrag der Minimalarbeitsspannung $U_m$ positiv bzw. negativ verschobene Momentanwert der Idealnetzspannung in einer ersten Komparatorreihe (28), bzw. in einer zweiten Komparatorreihe (29) mit den einzelnen Stufenspannungen verglichen wird und bei positivem Ueberschreiten einer Stufenspannung im Anodenanschluss (11) der n-Kanal-Transistoren der Schalttransistor der nächstpositiveren Spannungsstufe leitend gemacht wird, bzw. im Anodenanschluss (12) der p-Kanal-Transistoren der Schalttransistor der nächstnegativeren Spannungsstufe gesperrt wird.

5. Einrichtung nach Anspruch 1, dadurch gekennzeichnet, dass die Minimalarbeitsspannung $U_m$ im Bereich 0,2- bis 0,4- facher Stufenspannung $\triangle U$ liegt.

6. Einrichtung nach Anspruch 4, dadurch gekennzeichnet, dass die Komparatoren der Komparatorreihen (28, 29) mit einer leichten Schalthysterese versehen sind.

7. Einrichtung nach Anspruch 1, dadurch gekennzeichnet, dass die Gleichspannungsquelle (4) aus induktivitätsarmen Akkumulatoren- oder Kondensatorenbatterien aufgebaut ist und alle Spannungsstufen in paralleler Anspeisung aufgeladen werden.

8. Einrichtung nach Anspruch 7, dadurch gekennzeichnet, dass die Speisung der Akkumulatoren- oder Kondensatorenbatterien von einem Gleichspannungszwischenkreis (34), über einen elektronischen Schalter (35) getaktet, auf die Primärwicklung (36) eines Transformators (37) erfolgt und alle Spannungsstufen einzeln über synchron zum primärseitigen Schalter (35) betätigte elektronische Schalter (38) mit untereinander gleichen Sekundärwicklungen (39) auf den Transformator (37) verbunden sind.

9. Einrichtung nach Anspruch 7, dadurch gekennzeichnet, dass die installierte Stufenkapazität der Akkumulatoren- und Kondensatorenbatterien mit zunehmender Entfernung der Spannungstufe vom Nulleiteranschluss (0) abnimmt.

Claims

1. System for producing an alternating voltage with low source impedance, comprising a circuit arrangement with a transistorized push-pull circuit (2) whose output forms a first conductor (P) of the alternating voltage source, an ideal mains voltage generator (1) whose signal is applied across a second conductor (N) and a driving connection of the push-pull circuit and a d.c. voltage source (4) symmetrically stepped with reference to the second conductor, with essentially equal value step voltages $\triangle U$, characterized in that the push-pull circuit is in the form of a complementary circuit and the anode connections (11, 12) of transistors (8, 9) of the push-pull complementary circuit controlled by the ideal mains voltage generator are switched interruption-free under the voltage steps such that across each transistor a predetermined minimum working voltage $U_m$ is at no time fallen below and a maximum working voltage equal to the sum of the minimum working voltage $U_m$ and the step voltage $\triangle U$ is at no time exceeded.

2. System according to claim 1, characterized in that in an electronic switching block (3) the anode connection (11) of the n-channel transistors is connected essentially with each voltage step ($U_{CP}$, $U_{BP}$, $U_{AP}$, O, $U_{AN}$, $U_{BN}$) via a series connection of diode and switching transistor (14, CP1 ; 15, BP1 ; 16, AP1 ; 17, 01 ; 18, AN1 ; 19, BN1), and that the anode connection (12) of the p-channel transistors is connected essentially with each voltage step ($U_{CN}$, $U_{BN}$, $U_{AN}$, O, $U_{AP}$, $U_{BP}$) via a series connection of diode and switching transistor (27, CN2 ; 26, BN2 ; 25, AN2 ; 24, 02 ; 23, AP2 ; 22, BP2).

3. System according to claims 1 and 2, characterized in that the anode connection (11) of the n-channel transistors is not connected to the most negative voltage step or steps ($U_{DN}$), that the most negative connected step ($U_{CN}$) is connected only via a diode (20) and the connection with the most positive step ($U_{DP}$) is made only via a switching transistor (DP1) and that the same applies to the connection of the anode connection (12) of the p-channel transistors.

4. System according to claims 1 and 2, characterized in that the driving of the switching transistors in the electronic switching block (3) takes place by means of a control electronics block (5) in which the instantaneous value of the ideal mains voltage, positively respectively negatively displaced by the value of the minimum working voltage $U_m$, is compared in a first array of comparators (28) respectively a second array of comparators (29) with the individual step voltages, and in the case of a positive exceeding of a step voltage in the anode connection (11) of the n-channel transistors, the switching transistor of the next more positive step is rendered conducting respectively in the anode connection (12) of the p-channel transistors, the switching transistor of the next more negative voltage step is rendered non-conducting.

5. System according to claim 1, characterized in that the minimum working voltage $U_m$ is in the range of 0.2 to 0.4 times the step voltage $\triangle U$.

6. System according to claim 4, characterized in that the comparators of the comparator arrays (28, 29) are provided with a slight switching hysteresis.

7. System according to claim 1, characterized in that the d.c. voltage source (4) is composed of low inductive accumulator or capacitor batteries and that all voltage steps are charged in parallel way.

8. System according to claim 7, characterized in that the supply to the accumulator or capacitor batteries from a d.c. link (34) clocked via an electronic switch (35) takes place on the primary winding (36) of a transformer (37) and that all voltage steps are individually connected to the transformer (37) with mutually identical secondary windings (39) via electronic switches (38) actuated in synchronism with the primary-side switch (35).

9. System according to claim 7, characterized in that the installed step capacitance of the accumulator and capacitor batteries decreases with increased distance of the voltage step from the neutral conductor connection (0).

## Revendications

1. Installation pour la production d'une tension alternative à basse impédance de source, contenant un dispositif de circuits avec un circuit symétrique transistorisé (2) dont la sortie forme un premier conducteur (P) de la source de tension alternative, d'un générateur de tension de réseau idéale (1), dont le signal se situe entre un deuxième conducteur (N) et un raccordement de comnande du circuit symétrique et d'une source de tension continue (4) symétriquement étagée par rapport au second conducteur, avec des tensions d'étage $\triangle U$ essentiellement de même niveau, caractérisée en ce que le circuit symétrique est façonné comme circuit complémentaire et que les raccords d'anode (11, 12) des transistors (8, 9) du circuit symétrique et complémentaire commandé par le générateur de tension de réseau idéale sont commutés sans interruption sous les étages de tension de façon que pour chacun des transistors, à aucun moment, une tension de travail minimale prédéfinie $U_m$ n'est dépassée négativement et à aucun moment une tension de travail maximale égale à la somme de la tension de travail minimale $U_m$ et de la tension d'étage $\triangle U$ n'est dépassée.

2. Installation selon la revendication 1, caractérisée en ce que dans une partie électronique de commutation (3) le raccord d'anode (11) des transistors à canal n est relié essentiellement à chaque étage de tension ($U_{CP}$, $U_{BP}$, $U_{AP}$, O, $U_{AN}$, $U_{BN}$) par un circuit de série diode-transistor de commutation (14, CP1 ; 15, BP1 ; 16, AP1 ; 17, 01 ; 18, AN1 ; 19, BN1), et que le raccord d'anode (12) des transistors à canal p est relié essentiellement à chaque étage de tension ($U_{CN}$, $U_{BN}$, $U_{AN}$, O, $U_{AP}$, $U_{BP}$) par un circuit de série diode-transistor de commutation (27, CN2 ; 26, BN2; 25, AN2 ; 24, 02 ; 23, AP2 ; 22, BP2).

3. Installation selon la revendication 1 et 2, caractérisée en ce que le raccord d'anode (11) des transistors à canal n n'est pas relié à l'étage de tension le plus négatif ou aux étages de tension les plus négatifs ($U_{DN}$), que l'étage relié le plus négatif ($U_{CN}$) n'est relié que par une diode (20) et que la liaison avec l'étage le plus positif ($U_{DP}$) n'est assurée que par l'intermédiaire d'un transistor de commutation (DP1) et que pour la liaison du raccord d'anode (12) des transistors à canal p il en est de même par analogie.

4. Installation selon la revendication 1 et 2, caractérisée en ce que l'excitation des transistors de commutation dans la partie électronique de commutation (3) est assurée par une partie électronique de commande (5) dans laquelle la valeur instantanée de la tension idéale du réseau décalée positivement respectivement négativement du montant de la tension

de travail minimale $U_m$ est comparée dans une première rangée (28) respectivement seconde rangée (29) de comparateurs aux différentes tensions d'étage et qu'en cas de dépassement positif d'une tension d'étage dans le raccord d'anode (11) des transistors à canal n le transistor de commutation de l'étage de tension positif suivant est rendu conducteur, respectivement dans le raccord d'anode (12) des transistors à canal p le transistor de commutation de l'étage de tension négatif suivant est bloqué.

5. Installation selon la revendication 1, caractérisée en ce que la tension de travail minimale $U_m$ se situe dans la zone allant de 0,2 à 0,4 fois la tension d'étage $\triangle U$.

6. Installation selon la revendication 4, caractérisée en ce que les comparateurs des rangées de comparateurs (28, 29) sont dotés d'une légère hystérésis de commutation.

7. Installation selon la revendication 1, caractérisée en ce que la source de tension continue (4) est constituée par des batteries d'accumulateurs ou de condensateurs à faible inductivité, et que tous les étages de tension sont chargés en alimentation parallèle.

8. Installation selon la revendication 7, caractérisée en ce que l'alimentation des batteries d'accumulateurs ou de condensateurs s'effectue à partir d'un circuit intermédiaire de tension continue (34), par l'intermédiaire d'un commutateur électronique (35) sur l'enroulement primaire (36) d'un transformateur (37) et que tous les étages de tension sont reliés séparément au transformateur (37) par l'intermédiaire de commutateurs (38) actionnés électroniquement en synchronisation avec le commutateur côté primaire (35), avec des enroulements secondaires (39) identiques entre eux.

9. Installation selon la revendication 7, caractérisée en ce que la capacité d'étage installée des batteries d'accumulateurs et de condensateurs diminue lorsqu'augmente l'éloignement des étages de tension du raccordement du conducteur neutre (0).

FIG.1

EP 0 262 164 B1

**FIG.2**